# EUROPEAN PATENT APPLICATION

(11) **EP 3 035 535 A1**
(43) Date of publication of application: **22.06.2016**
(21) Application number: 14199418.6
(22) Date of filing: 19.12.2014
(51) Int. Cl.: H03L 7/091, H03L 7/081

(54) **ADPLL with a TDC having a reduced DTC range**

(71) Applicant: Stichting IMEC Nederland, 5656 AE Eindhoven (NL)
(72) Inventor: Liu, Yao-Hong, B-3001 Leuven (BE)
(74) Representative: Gevers Patents

(57) **Abstract**

An All-Digital-Phase-Locked-Loop, ADPLL, arranged for generating a DCO output signal and a feedback loop comprising a set of components for controlling the DCO. The components comprising a Time-to-Digital Converter provided for performing phase detection within a predetermined observation window between a reference signal and an enable signal, a first subset of components arranged for generating the enable signal from the DCO output signal, and a second subset of components arranged for positioning the reference signal within the predetermined observation window. The first subset of components comprises a multiphase generator unit deriving from the DCO output signal a plurality of phase-shifted DCO copies and a phase selection unit for selecting on the basis of the phase setting control signal a DCO copy having an appropriate phase-shift for generating the enable signal. The DTC of the second subset of components has a reduced range with respect to that of the period of the multiphase generator output signals over at least part of the frequency range of the DCO.

## Description

### Technical field

The present disclosure relates to an All-Digital-Phase-Locked-Loop (ADPLL) and more specifically to an ADPLL with a Time-to-Digital-Converter (TDC) for phase detection and a Digital-to-Time- Converter (DTC) for delaying a reference signal that is supplied to the TDC, the DTC having a reduced range.

### Background art

Ultra-low-power (ULP) transceivers enable short-range networks of autonomous sensor nodes for wireless personal area network (WPAN) applications, e.g., Bluetooth Smart and Zigbee. RF Phase-Locked-Loops (PLL) for frequency synthesis and modulation consume a significant share of the total transceiver power, making sub-mW PLLs key to realize ULP WPAN radios. Compared to analog PLLs, all-digital PLLs (ADPLLs) are preferred in nanoscale CMOS as they offer benefit of a smaller area overhead, programmability, capability of extensive self-calibrations, and easy portability. However, analog PLLs currently still dominate the field of ULP WPAN radios, since the time-to-digital-converter (TDC) of an ADPLL is power hungry.

A known approach for minimising the power consumption of a TDC circuit in the ADPLL is to reduce the activity of the TDC so that it operates only within a predetermined observation window. Such a TDC is known from J. Zhuang, et al., "A Low-Power All-Digital PLL Architecture Based on Phase Prediction," ICECS, 2012, where a 2.1-2.7GHz fractional-N ADPLL for WPAN applications DTC-assisted snapshot TDC is presented. In this implementation TDC snapshotting is implemented to reduce the sampling rate of the TDC from FCKVD2 to FREF. A Digital-to-Time Converter (DTC) is provided for reducing the detection range of the TDC detection range to less than 1/10 of the DCO output signal period, leading to a significant power reduction. The accumulated fractional part of the frequency command word, FCWfrac, controls the DTC to delay the reference signal FREF such that the delayed reference clock FREFdly is almost aligned with CKVD2, once the loop is locked. FREFdly also triggers the snapshot to catch the first CKVD2 edge so that only one CKVD2 edge, CKVD2S, per reference period is fed to the TDC. By capturing only one edge, the snapshot technique guarantees that the TDC has the minimum activity and consume minimum power. Moreover, the snapshotting also minimize the supply switch noise during TDC operation. A reduced-range TDC operating at the reference frequency (32MHz) then compares the edge of CKVD2S with FREF_{dly} to provide the fractional phase error, PHE_{F}. This approach reduces both sampling speed and detection range of TDC, leading to around 200x power reduction. A Digital-to-Time Converter (DTC) is provided for reducing the dynamic range of the TDC by adjusting the delay of the reference signal so that it can arrive within the predetermined observation window. The delay range of the DTC is provided for covering one full clock cycle of the DCO output signal cycle plus some margin. Therefore, for a low frequency DCO signal a substantially long delay range DTC is required. However, providing a long delay range DTC may increase the fractional spurs generated in the ADPLL due to mismatches introduced between the DTC delay stages during the design phase, which may lead to the degradation of the overall ADPLL performance, e.g. by introducing unwanted phase noise, and sometimes may even lead to an unstable ADPLL locking.

### Summary of the disclosure

It is an aim of the present disclosure to provide an ADPLL, which does not show the drawbacks of the prior art.

This aim is achieved according to the disclosure with the ADPLL showing the technical characteristics of the first independent claim.

More in particular according to embodiments of the present disclosure, an All-Digital-Phase-Locked-Loop (ADPLL) is provided comprising a Digitally Controlled Oscillator (DCO) arranged for generating a DCO output signal from a Frequency Code Word (FC), and a feedback loop comprising a set of components for controlling the DCO. The set of components comprise a Time-to-Digital Converter (TDC) provided for performing phase detection within a predetermined observation window. The TDC is arranged for receiving at least a reference signal having a first offset delay and an enable signal having a second offset delay and defining the predetermined observation window. The TDC is arranged for generating a TDC output code indicative of the phase difference between the reference signal and the enable signal measured within the predetermined observation window. The set of components comprises a first subset of components arranged for generating the enable signal from the DCO output signal, such that the enable signal contains a transition edge derived from the DCO output signal and is arranged for activating the TDC so as to measure the phase difference between the reference signal and the enable signal within the predetermined observation window. The set of components comprises a second subset of components arranged for positioning the reference signal within the predetermined observation window by adjusting the first offset delay based on a phase setting control signal generated on the basis of the FCW. The first subset of components in the feedback loop comprises, in sequence, a multiphase generator unit deriving from the DCO output signal a plurality of phase-shifted DCO copies and a phase selection unit, connected to the multiphase generator unit, for selecting on the basis of the phase setting control signal a DCO copy having an appropriate phase-shift for generating the enable signal. For example, the multiphase generator may be any circuit suitable for generating a number of phase-shifted signal copies from an original signal, such as a multiphase frequency divider, a delay line and the like. The second subset of components comprises a Digital-To-Time Converter (DTC) which has a reduced range with respect to that of the DCO copies, when the DCO is set at the lowest frequency of its range. This means that the DTC has less delay stages than theoretically needed for covering a full cycle of the multiphase generator output over the entire frequency range of the DCO.

It has been found that by providing a multiphase generator a plurality of phase-shifted DCO copies may be generated each shifted from one another by a number of phase degrees. For example, in the case where the multiphase generator is arranged for generating four phase-shifted DCO copies, each phase-shifted DCO copy may be shifted from one another by 90 degrees. The phase difference between the DCO copies generated by the multiphase generator may be indicative of a time delay difference between each DCO copy. By providing a phase selection unit arranged for receiving the phase-shifted DCO copies, an appropriate phase-shifted DCO copy may be selected for generating the enable signal. In this way, the position of the enable signal with respect to the reference signal may be adjusted by a value defined by the phase shift of the DCO copy selected. Accordingly, a DTC may be provided with a reduced dynamic range compared to the solutions provided in the prior art for adjusting the position of the reference signal. This is because, by adjusting the position of the enable signal the delay range requirements within which the reference signal needs to be adjusted by the second subset of components, in particular the DTC, may be significantly reduced. As a result, a reduced delay range DTC, i.e having a reduced number of delay stages, may be provided, which may be arranged for covering only a portion of the multiphase generator period, at least for part of the frequency range of the DCO. It has been found that providing a reduced delay range DTC may lead to a significant reduction in the fractional spurs generated in the ADPLL due to the mismatches between the delay stages.

According to embodiments of the present disclosure, the selection of a phase-shifted DCO output signal copy by the first subset of components is a coarse delay adjustment and the reference signal position adjustment by the second subset of components is a fine delay adjustment. In this way, the phase selection unit may be operated for effecting coarse delay adjustments to the enable signal, while the DTC for effecting fine delay adjustments to the reference signal. As a result, the dynamic range of the TDC may be reduced without having to provide a DTC having a delay range capable for covering one full period of the DCO copies, when the DCO is set at the lowest frequency of its range. In this way, the fractional spurs generated in the ADPLL may be significantly reduced. Moreover, the area overhead of the ADPLL may also be reduced by providing a smaller area DTC having a reduced number of delay stages in comparison to the solutions found in the prior art.

According to embodiments of the present disclosure, the second subset of components are arranged for further fine-tuning the first offset delay of the reference signal so that a transition edge thereof is positioned substantially in the middle of said predetermined observation window. By positioning the reference signal in the middle of the predetermined observation window it is ensured that the TDC is provided with sufficient margin to both previous and the proceeding DCO output signal cycles.

According to embodiments of the present disclosure, a first part of the phase setting control signal comprises the Most Significant Bits (MSBs) and a second part of the phase setting control signal the Least Significant Bits (LSBs), the first part controlling the phase selection unit and the second part controlling the DTC. For example, in the case where the multiphase generator is arranged for generating at least four phase-shifted DCO output signal copies, the two MSBs of the phase setting control signal may be provided to the phase selection unit. For example, the phase selection unit may be a multiplexer arranged for selecting one of the phase-shifted DCO copies received at its input. It has been found that by controlling the phase selection unit by the phase setting signal, the position of the enable signal may be dynamically adjusted with respect to the reference signal on the basis of the Frequency Code Word (FCW) used for generating the phase setting signal. Moreover, by controlling the phase selection unit by the MSBs of the phase setting signal, it may be ensured that the phase selection unit is only activated for predetermined frequency DCO output signals, thereby minimising the power consumption contributed by the phase selection unit to the ADPLL.

### Brief description of the drawings

The disclosure will be further elucidated by means of the following description and the appended figures.
Figure 1 shows an example of a prior art ADPLL.
Figure 2a and 2b show the relationship between DTC code and the generated DTC delay effected to the reference signal FREF.
Figure 3 shows an example of an ADPLL according to embodiments of the present disclosure.
Figure 4 shows an example of the phase-shifted DCO copies generated from the multiphase generator according to embodiments of the present disclosure.
Figure 5a and 5b shows an example of the relationship between DTC code applied to the DTC and the selection of a phase-shifted DCO copy from the phase selection unit according to embodiments of the present disclosure.
Figure 6a and 6b shows an example of the fractional spurs generated respectively for a prior art DTC implementation and a DTC implementation according to embodiments of the prior art.
Figure 7a and 7b shows an example of the fractional spurs generated respectively with 10 degrees IQ mismatch and with a tunable DCO buffer according to embodiments of the present disclosure.

### Detailed description of preferred embodiments

The present disclosure will be described with respect to particular embodiments and with reference to certain drawings but the disclosure is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the disclosure described herein can operate in other orientations than described or illustrated herein.

Furthermore, the various embodiments, although referred to as "preferred" are to be construed as exemplary manners in which the disclosure may be implemented rather than as limiting the scope of the disclosure.

The term "comprising", used in the claims, should not be interpreted as being restricted to the elements or steps listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising A and B" should not be limited to devices consisting only of components A and B, rather with respect to the present disclosure, the only enumerated components of the device are A and B, and further the claim should be interpreted as including equivalents of those components.

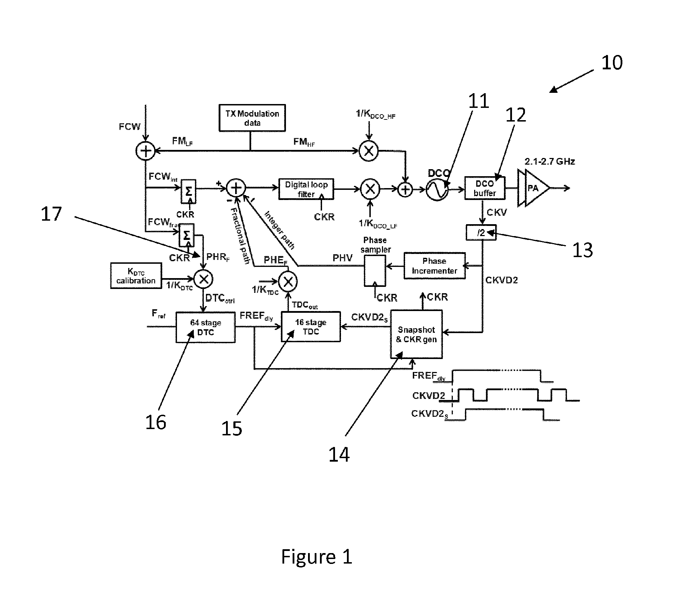

Embodiments of the present disclosure will be explained with reference to the examples shown in figures 1 to 7.

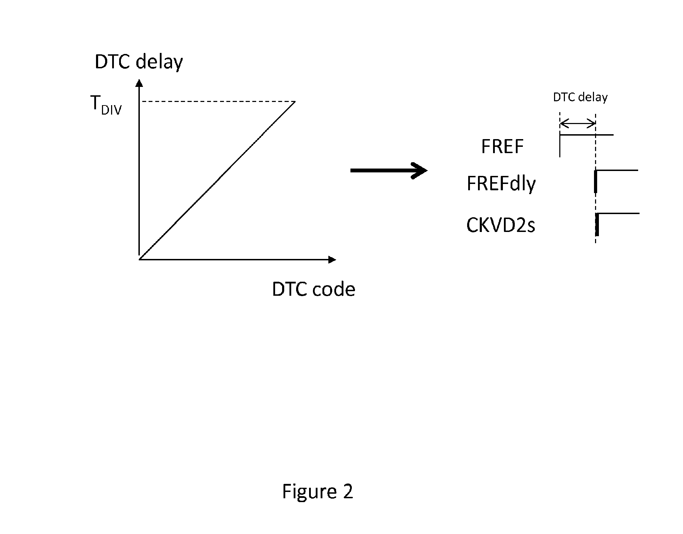

Figure 1 shows an example of an ADPLL circuit 10, which is arranged for generating using a Digital Control Oscillator (DCO) 11 a DCO output signal, e.g. CKV, having a predetermined frequency. The ADPLL is arranged for receiving a reference frequency signal, e.g. FREF, and generate based on a Frequency Code Word (FCW), which may be multiple of the reference signal, the desired DCO output signal, e.g. CKV. In order to ensure that the DCO is maintain stabled within the desired frequency range, the ADPLL may be provided with a feedback loop comprising a set of components for controlling the DCO. The components in the feedback loop comprise components for phase detection, which may be done in stages by means of for example a subset for detecting a coarse part of the phase e.g. using a phase incrementor for detecting the integer part of the phase, and a subset for detecting a fine part of the phase, for example a subset for detecting the fractional part of the phase, e.g. using a TDC 15, such as a flash TDC, arranged for performing phase detection within a predetermined observation window. The TDC 15 may be arranged for receiving at least a reference signal having a first offset delay and an enable signal having a second offset delay and defining the predetermined observation window. The TDC 15 may be arranged for generating a TDC output code indicative of the phase difference between the reference signal and the enable signal measured within the predetermined observation window. For example, the TDC 15 may be arranged for measuring the fractional phase differences between the significant edge of the enable signal and the reference signal and accordingly generate a TDC output indicative of the fractional phase error (PHE_{f}). The TDC 15 may be arranged for performing phase detection between a reference signal and an enable signal derived from the DCO output signal, e.g. CKV, within a predetermined observation window. To generate the enable signal, the feedback loop may be provided with a first subset of components arranged for generating the enable signal based on a reduced rate DCO output signal, e.g. CKVD2, generated from a multiphase generator 13 such that the enable signal contains a transition edge derived from the DCO output signal. For example, the multiphase generator may be any circuit suitable for generating a number of phase-shifted signal copies from an original signal, such as a multiphase frequency divider, a delay line and the like. The enable signal generated may be arranged for activating the TDC 15 so as to measure the phase difference between the reference signal and the enable signal within the predetermined observation window. For example, the first subset of components may comprise a snapshotting circuit 14, which may be triggered by the reference signal for generating an enable signal representing only one edge of the reduced rate DCO signal, e.g. CKVD2. In this way, only one edge of the reduced rate DCO signal, e.g. may be fed to the TDC per reference period, thereby reducing the activity of the TDC 15 leading to a reduced power consumption. By using the reference signal, e.g. FREF, for activating the TDC 15, the sampling rate of the TDC 15 may be reduced to the frequency rate of the reference signal. In order to reduce the dynamic range of the TDC 15, a second subset of components may be provided, which may be arranged for positioning the reference signal within the predetermined observation window of the TDC. For example, this may be achieved by providing a Digital-to-Time Converter (DTC) 16, which may be arranged for delaying the reference signal based on a phase setting control signal, e.g. PHR_{f}, generated on the basis of FCW. In this way, a reduced range TDC 15 may be provided for performing the fractional phase difference, thereby reducing the area overhead of the ADPLL 10. The DTC 16 may be arranged for covering one full period of the signal generated by the multiphase generator 13 plus some margin. Therefore, in order to cover the full range of frequencies generated by the ADPLL 10, the DTC 16 may be required to have a large number of delay stages, which are arranged to be operated by a DTC code generated by the phase setting signal, PHRf. The relationship between the DTC code and the DTC delay effected to the reference signal, FREF, is shown in figures 2a and 2b.

However, providing a DTC with a large dynamic range, i.e. large number of delay stages, suitable for covering one full period of the signal generated by the multiphase generator 13, CKVD2, may significantly increase the fractional spurs generated in the ADPLL. This is due to the mismatches between the delay stages of the DTC 16, which may degrade the phase noise leading to the degradation of the ADPLL performance.

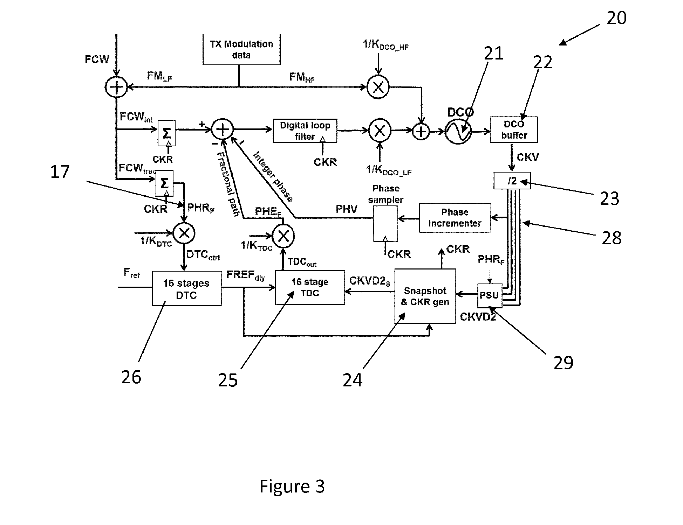

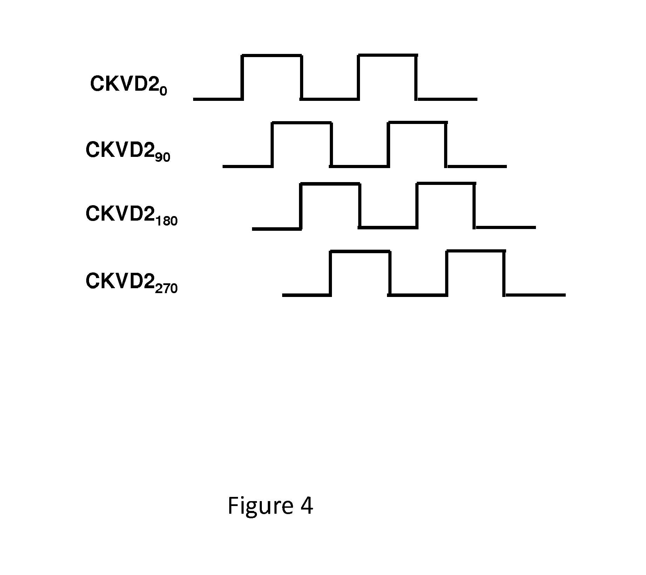

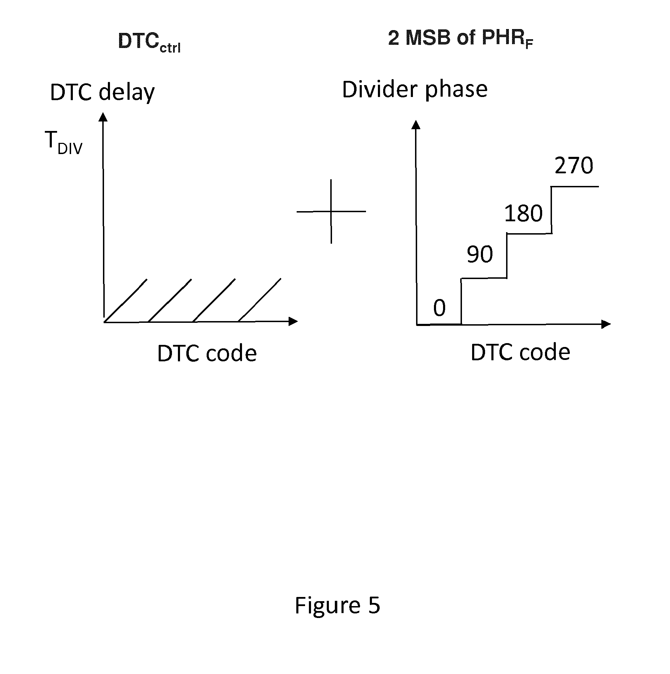

According to embodiments of the present disclosure, in order to reduce the generation of fractional spurs the ADPLL 20 may be provided, as shown in figure 3. The ADPLL 20 functions in a similar manner to the ADPLL 10 of figure 1, therefore for simplicity only the main differences will be explained. In the ADPLL 20, the first subset of components in the feedback loop may be provided, in sequence, with a multiphase generator unit 23 deriving from the DCO output signal, CKV, a plurality of phase-shifted DCO copies 28 and a phase selection unit 29, connected to the multiphase generator unit 23, for selecting on the basis of the phase setting control signal a DCO copy having an appropriate phase-shift for generating the enable signal, CKVD2s. In this way, the DTC 26 of the second subset of components may be provided with a reduced range with respect to the period of the DCO copies, when the DCO is set at the lowest frequency of its range.. This is because, by providing a multiphase generator a plurality of phase-shifted DCO copies, may be generated each shifted from one another by a number of phase degrees. For example, as shown in figure 4, in the case where the multiphase generator 23 is arranged for generating four phase-shifted DCO copies 28, each phase-shifted DCO copy may be shifted from one another by 90 degrees. The phase difference between the DCO copies generated by the multiphase generator may be indicative of a time delay difference between each DCO copy. This delay difference between each DCO copy may be used for delaying the enable signal This may be achieved by providing the phase selection unit 29, which is arranged for receiving the phase-shifted DCO copies 28, and based on a control signal select an appropriate phase-shifted DCO copy for generating the enable signal. In this way, the position of the enable signal with respect to the reference signal may be adjusted by a value defined by the phase shift of the DCO copy selected. As a result, the DTC 26 may be provided with a reduced dynamic range since it is required to cover only a portion of the cycle of the DCO, rather than the full cycle. The relationship between the delay, T_{DIV}, effected to the reference signal by a reduced dynamic range DTC is shown in figure 5a. Figure 5b shows the relationship between the delay effected to the enable signal from each of the phase-shifted DCO copies.

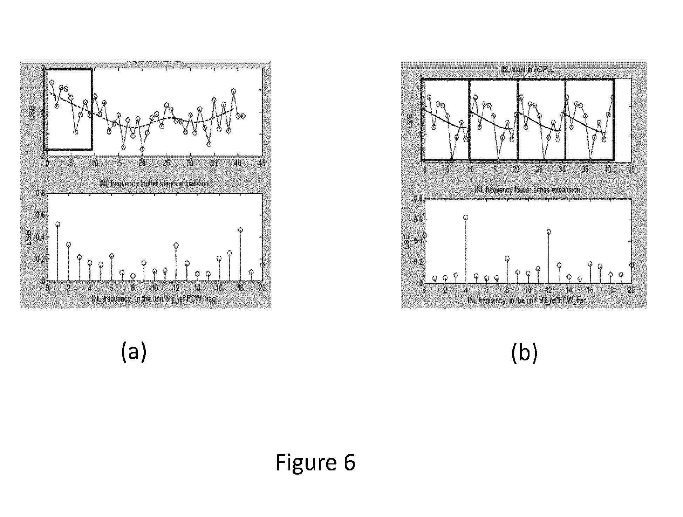

According to embodiments of the present disclosure, the phase selection unit 29 may be arranged for being controlled by the phase setting signal, PHR_{f}, used for generating the DTC control code. In this way, the selection of the delay to be effected to the enable signal may be dynamically selected based on the Frequency Code Word supplied to the ADPLL. For example, the phase selection unit 29 may be arranged for being controlled by a first part of the phase setting control signal, PHR_{f}, which may comprise the Most Significant Bits (MSBs), while the DTC code may be generated by a second part of the phase setting signal, PHR_{f}, which may comprise the Least Significant Bits (LSBs). For example, in the case where the multiphase generator 23 is arranged for generating at least four phase-shifted DCO output signal copies 28, the two MSBs of the phase setting control signal, PHR_{f}, may be provided to the phase selection unit 29. The phase selection unit may be a multiplexer arranged for selecting one of the phase-shifted DCO copies 28 received at its input. According to embodiments of the present disclosure, the DTC 26 may be arranged for effecting fine delay adjustments to the reference signal, while the phase selection unit 29 may be arranged for effecting coarse delay adjustments to the enable signal (the TDC may be arranged for effecting even finer delay adjustments to the reference signal). As a result, using fine and coarse adjustment units, in the form of DTC 26 and phase selection unit 29, the dynamic range of the TDC may be reduced without the need for providing a DTC having a dynamic range configured for covering a full cycle of the signal generated by the multiphase generator 23, thereby reducing the fractional spurs generated in the ADPLL due to the mismatch between the DTC delay stages. Figures 6a and 6b shows respectively a fractional spur simulation results for an ADPLL having a long dynamic range DTC, as in the prior art solutions, and for an ADPLL having a reduced range DTC according to embodiments of the present disclosure. Comparing the figures 6a and 6b, it can be seen that the first three fraction tones in the simulation results for the ADPLL with a reduced DTC are significantly lowered than the corresponding ones for an ADPLL with a full dynamic range DTC. Therefore, by using the phase-shifted DCO copies generated by the multiphase generator 23 for effected a coarse delay adjustment to the enable signal may significantly lower the fraction spurs generated in the ADPLL during the operation of the DTC 26.

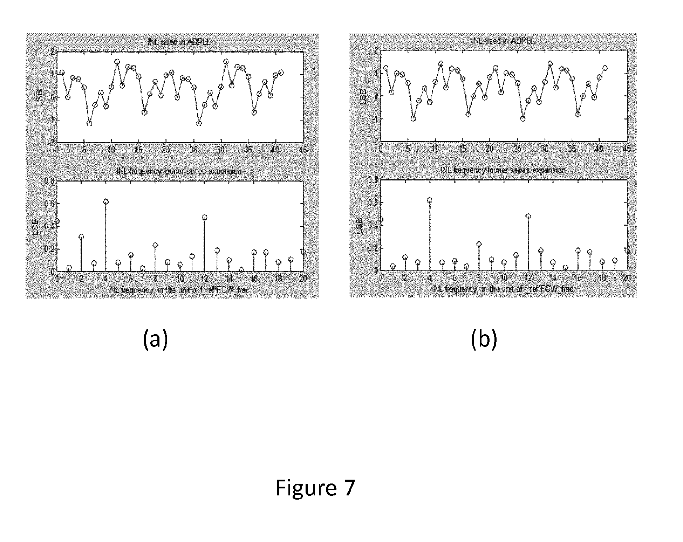

Another source of fractional spurs is In-Phase/Quadrature (I/Q) mismatches caused among others by distortion and variations in the system components. According to the present disclosure, the ADPLL may be provided with a DCO buffer 22 having tunable voltage characteristics arranged for compensating the I/Q mismatches in the system thereby minimising the fractional spurs generated, as for example described in EP13192650. Figures 7a and 7b show respectively the fractional spur simulation results generated for a 10 degree I/Q phase mismatch for an ADPLL according to solutions of the prior art and an ADPLL having a tunable DCO buffer. From the comparison of the figures 7a and 7b it can be seen that the fractional spurs, especially the second fractional tone, for an ADPLL having no tunable DCO buffer is significantly higher than the ADPLL system with the tunable DCO buffer. As a result, by providing a tunable DCO buffer 22 in the ADPLL having tunable voltage characteristics, the I/Q phase mismatches can be compensated thereby significantly reducing the generation of fractional spurs in the ADPLL.

## Claims

1. An All-Digital-Phase-Locked-Loop (20), ADPLL, comprising a Digitally Controlled Oscillator (21), DCO, arranged for generating a DCO output signal from a Frequency Code Word, FCW, and a feedback loop comprising a set of components for controlling the DCO (21), the components comprising:
a Time-to-Digital Converter (25), TDC, provided for performing phase detection within a predetermined observation window, the TDC (25) being arranged for receiving at least a reference signal having a first offset delay and an enable signal having a second offset delay and defining the predetermined observation window, the TDC (25) being arranged for generating a TDC output code indicative of the phase difference between the reference signal and the enable signal measured within the predetermined observation window;
a first subset of components arranged for generating the enable signal from the DCO output signal, such that the enable signal contains a transition edge derived from the DCO output signal and is arranged for activating the TDC (25) so as to measure the phase difference between the reference signal and the enable signal within the predetermined observation window; and
a second subset of components arranged for positioning the reference signal within the predetermined observation window by adjusting the first offset delay based on a phase setting control signal generated on the basis of the FCW, the second subset of components comprising a Digital-To-Time Converter (26), DTC;
**characterised in that** the first subset of components in the feedback loop comprises, in sequence, a multiphase generator (23) unit deriving from the DCO output signal a plurality of phase-shifted DCO copies (28) and a phase selection unit (29), connected to the multiphase generator unit, for selecting on the basis of the phase setting control signal a DCO copy having an appropriate phase-shift for generating the enable signal;
and **in that** the DTC (26) of the second subset of components has a reduced range with respect to the period of the DCO copies, when the DCO is set at the lowest frequency of its range.

2. The ADPLL (20) of claim 1, wherein the selection by the first subset of components is a coarse delay adjustment and the reference signal position adjustment by the second subset of components is a fine delay adjustment.

3. The ADPLL (20) of claims 1 or 2, wherein the second subset of components are arranged for further fine-tuning the first offset delay of the reference signal so that a transition edge thereof is positioned substantially in the middle of said predetermined observation window.

4. The ADPLL (20) of any one of the preceding claims, wherein a first part of the phase setting control signal comprises the Most Significant Bits, MSBs, and a second part of the phase setting control signal the Least Significant Bits, LSBs, the first part controlling the phase selection unit (29) and the second part controlling the DTC (26).

5. The ADPLL (20) of any one of the preceding claims, wherein the multiphase generator (23) is arranged for generating at least four phase-shifted DCO output signal copies.

6. The ADPLL (20) of any one of the preceding claims, wherein the two MSBs of the phase setting control signal are provided to the phase selection unit.

7. The ADPLL (20) of any one of the preceding claims, wherein the phase selection unit (29) is a multiplexer arranged for being controlled by the phase setting control signal.

8. The ADPLL (20) of any one of the preceding claims, wherein the DTC comprises a number of delay stages together arranged for applying a delay shorter than the period of the DCO copies, when the DCO is set at the lowest frequency of its range.

9. The ADPLL (20) of any one of the preceding claims, wherein the DTC comprises a number of delay stages together arranged for applying a delay shorter than half the period of the DCO copies, when the DCO is set at the lowest frequency of its range.

10. The ADPLL (20) of any one of the preceding claims, wherein the DTC comprises a number of delay stages together arranged for applying a delay shorter than a quarter of the period of the DCO copies, when the DCO is set at the lowest frequency of its range.

11. The ADPLL (20) of any one of the preceding claims, wherein the DCO (21) comprises a DCO buffer (22) with tunable voltage transfer characteristics.

12. The ADPLL (20) of any one of the preceding claims, wherein the TDC (25) is a flash TDC.

13. A method for operating an All-Digital-Phase-Locked-Loop (20), ADPLL, comprising a Digitally Controlled Oscillator (21), DCO, arranged for generating a DCO output signal from a Frequency Code Word, FCW, and a feedback loop comprising a set of components for controlling the DCO (21), the method comprising the steps of:
a) activating a Time-to-Digital Converter (25), TDC, arranged for performing phase detection within a predetermined observation window, the TDC (25) being arranged for receiving at least a reference signal having a first offset delay and an enable signal having a second offset delay and defining the predetermined observation window, wherein the step of activating the TDC (25) comprises the steps of :
a1) providing a reference signal to the TDC (25), and
a2) generating by means of a first subset of components the enable signal from the DCO output signal, such that the enable signal contains a transition edge derived from the DCO output signal and is arranged for activating the TDC so as to measure the phase difference between the reference signal and the enable signal within the predetermined observation window;
b) positioning, by means of a second subset of components, the reference signal within the predetermined observation window by adjusting the first offset delay based on a phase setting control signal generated on the basis of the FCW, the second subset of components comprising a Digital-To-Time Converter (26), DTC;
**characterised in that** the first subset of components in the feedback loop comprises, in sequence, a multiphase generator (23) unit deriving from the DCO output signal a plurality of phase-shifted DCO copies (28) and a phase selection unit (29), connected to the multiphase generator unit;
**in that** the DTC (26) of the second subset of components has a reduced range with respect to the period of the DCO copies, when the DCO is set at the lowest frequency of its range;
and **in that** the positioning step comprises selecting, by means of the phase selection unit (29) and on the basis of the phase setting control signal, a DCO copy having an appropriate phase-shift for generating the enable signal.

14. The method of claim 13, wherein a first part of the phase setting control signal comprises the Most Significant Bits, MSBs, and a second part of the phase setting control signal the Least Significant Bits, LSBs, the first part controlling the phase selection unit (29) and the second part controlling the DTC (26).

15. The method of claim 13 or 14, wherein the multiphase generator (23) is arranged for generating at least four phase-shifted DCO output signal copies and wherein the two MSBs of the phase setting control signal are provided to the phase selection unit.
